**Europäisches Patentamt**

(19) **European Patent Office**

**Office européen des brevets**

(11) Publication number : **0 398 721 B1**

# (12) EUROPEAN PATENT SPECIFICATION

(45) Date of publication of patent specification :
**04.10.95 Bulletin 95/40**

(51) Int. Cl.⁶ : **H05K 3/02, H05K 3/38**

(21) Application number : **90305343.7**

(22) Date of filing : **17.05.90**

(54) **Thin copper foil for printed wiring board and method of manufacturing same.**

(30) Priority : **17.05.89 JP 123496/89**
**12.10.89 JP 265680/89**

(43) Date of publication of application :
**22.11.90 Bulletin 90/47**

(45) Publication of the grant of the patent :
**04.10.95 Bulletin 95/40**

(84) Designated Contracting States :
**DE GB**

(56) References cited :
**US-A- 3 998 601**
**WORLD PATENT INDEX LATEST, Accession**
**no. 82-19001E, week 10, Derwent Publications**
**Ltd., London, GB; JP-A-57 020347**

(72) Inventor : **Kajiwara, Toshiyuki**
**71 banchi,**
**Nakatomi-cho,**
**Nishinoyama**
**Yamashina-ku, Kyoto (JP)**
Inventor : **Tanii, Yoshinori**
**1-banchi,**
**Tenjindai 3-chome**
**Uji-shi, Kyoto (JP)**
Inventor : **Hashimoto, Kazuhiko**
**28-banchi,**
**Naka-machi,**
**Toijiin**
**Kita-ku, Kyoto (JP)**

(74) Representative : **Arthur, Bryan Edward et al**
**Withers & Rogers**
**4 Dyer's Buildings**
**Holborn**
**London EC1N 2JT (GB)**

(73) Proprietor : **FUKUDA KINZOKU HAKUFUN**
**KOGYO KABUSHIKI KAISHA**
**176, Nakanono-cho,**
**Muromachi-Nishiiru,**
**Matsubaradori**
**Shimokyo-ku, Kyoto (JP)**

## Description

### (1) Field of the Invention

The present invention relates to a copper foil composite for a printed wiring board and a method of manufacturing same and more particularly to the thin copper foil with a peelable copper foil support.

### (2) Description of the Prior Art

Recently, circuits in a printed wiring board assembled in electronic machines are going to high density and electric conductors of the circuits tend to be fine extremely according to rapid progress of compactization of the electronic machines.

To fulfil these requirements, it is ordinary to use a thin copper foil having a thickness of less than 12 μm wherein side etching seldom occurs. Since these thin copper foils are weak in strength, it is difficult to use them as they are creased or torn in handling. Therefore, as a copper foil for an outer layer of a multilayer printed wiring board, it is used a thin copper foil with a support which uses an aluminium foil or a copper foil, on a side of which a thin copper foil layer is deposited electrically to have a thickness of less than 12 μm on a side of the support.

As an example, it has been proposed to use a support which is prepared by depositing a chrome metal on a surface of a side of an electrolytic copper foil by means of chrome plating or the like, and then depositing a thin copper foil layer on the chrome metal so as to make a thin copper foil with a peelable deposited copper foil support (See Japanese patent publication Sho. 53-18329).

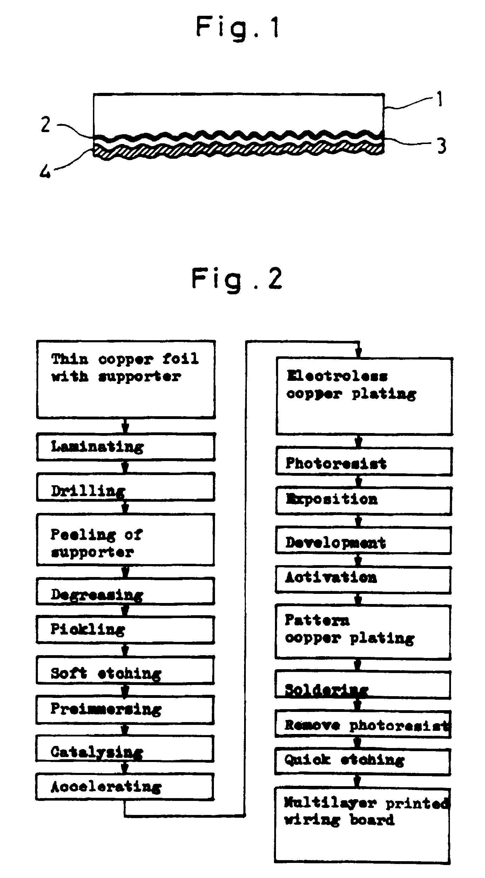

To make a multilayer board by using the thin copper foil with the supporter, it was carried out through such steps as shown in Fig. 2.

First, a prepreg comprising glass and epoxy was laid on both sides of a printed wiring board for inner layer and a copper foil with a support is laid on the outer side of the prepreg to face the copper foil support outwardly and then these were laminated one another under high pressure and temperature. The finished multilayer board was drilled at desired positions thereof and then the copper foil support was peeled off mechanically. Thereafter, in order to form an electric conductor in each of the drilled holes, electroless plating was given thereto after taking some kinds of pre-treatment. Next, the portions of the board except the circuit portions to be neccesitated were covered with a photoresist. A thin copper plating was given to the circuit portions and the electric conductor in the hole by utilizing a copper electroplating bath for through-holes and soldering was carried out thereon and thereafter the photoresist used was removed. Finally, the laminated board was etched with an etching liquid of alkaline ammonia in a manner of quick etching so as to produce a multilayer printed wiring board.

However, there remained some troubles when producing the thin copper foil with the support and also when producing a multilayer board by using same.

For instance, since a peel strength between the copper foil support and the thin copper foil layer, was dispersed widely and therefore the following troubles occurred to the thin copper foil with the support.

Where the peel strength was too weak, there were the following drawbacks.

① When the thin copper foil with the support was laminated with the prepreg under high pressure and temperature and at the time of taking out its laminated board from a press machine or at the time of cutting same in a desired size, the copper foil support was peeled off and it was likely that the thin copper foil layer on the surface of the laminated board was injured in handling the laminated board.

② In the process of drilling the laminated board, when a drill was drawn from the drilled hole, the copper foil support was peeled off and lifted from the board. As the result, the drilling process could not be continued.

Contrary to this, when the peel strength of the supporter was too strong, there were the following drawbacks.

③ After drilling, when the support was peeled off from the board mechanically, a part of the thin copper foil layer was injured or broken at an end thereof located around the holes.

④ Particularly, in a case of a laminated board in large size, it necessitated a remarkable strength in peeling off the support therefrom.

⑤ A part of the chrome plating layer was left on the surface of the thin copper foil layer after peeling off the support, and as the result desired conductive circuits could not be obtained.

⑥ The copper foil support of chrome plating, which was peeled off from the laminated board, contained a large amount of chrome and therefore it could not be reused as copper materials or disposed as a scrap.

⑦ To produce or manufacture the thin copper foil with the supporter, it ordinary used a chrome plating bath of strong acid including a high concentration of hexavalent chromium ions. Therefore, it costed a great deal in dealing with the waste fluid of plating. Further, since the plating liquid was electrolyzed with high current density, it produced a large amount of mist which was harmful to the human body.

Namely, through examination of the above mentioned drawbacks in connection with the conventional copper foil with a support, the inventors have found that there occurrs dispersion of a peel strength between the parting layer and the thin copper foil layer when the support is peeled off from the thin copper foil. This dispersion originates in the connection between the parting layer which is formed by means of chrome plating and the thin copper foil layer which is formed by means of copper plating.

The inventors have reached an idea that the dispersion may be solved by interposing between the above mentioned layers a suitable intermediate layer connectable thereto. We have reseached the composition of the intermediate layer in various ways and found that the dispersion of a peel strength can be controlled by forming a copper-nickel compound metal.

World Patent Index Latest, Accession no. 82-19001E, week 10, Derwent Publications Ltd., London GB, discloses a copper foil composite comprising a releasing layer composed of chromate thin film formed on the side face of a metal foil-supporting layer selected from Cu, Cu-alloy, Ni and Ni-alloy and a metal releasing layer composed of any metal (alloy) of Ni, Fe, Co, Cu, Sn and Zn on the layer and further a thin Cu layer not capable of self-supporting.

## Summary of the Invention

It is an object of the present invention to provide a thin copper foil for a printed wiring board and a method of manufacturing same which can stabilize a peel strength between a thin copper foil layer and a copper foil support at a practically suitable level in order to solve any problems occurred in dispersion of a peel strength of the support.

The present invention has another object to reuse the copper foil supporter which is peeled off after lamination.

To achieve the above objects, the present invention provides a copper foil composite for a printed wiring board as defined in claim 1.

Further, a method of manufacturing a copper foil composite for a printed wiring board according to the present invention is defined in claim 6.

Claim 5 defines the use of a copper foil composite according to the present invention for making a printed circuit board.

Therefore, since the peel strength between the copper foil supporter and the thin copper foil layer is stabilized at a suitable value, the present invention has the following advantages.

① The supporter cannot be peeled off while the thin copper foil with the support is laminated with the prepreg under high pressure and temperature.

② There occuurs no danger due to peeling off of the support while drilling and a drilling work cannot be interrupted.

③ At the time of peeling off the supporter after drilling, there is no danger to injure or brake the compound metal layer around the drilled holes.

④ The supporter may be easily peeled off from the laminated board by hand even if it is constructed in large scale.

⑤ The metal such as chromium which is insoluble in a soft etching liquid does not remain on the compound metal layer after peeling off of the supporter.

⑥ The copper foil supporter peeled off may be reused as an electrolytic copper of high purity since it takes no account of a chrome compound remained on the copper foil support.

⑦ To form the parting layer, a chromate plating bath of weak acid including hexavalent chromium ions of low concentration is used and a immersing process is used for evading production of a harmful mist. Therefore, there is little danger to the human body and it is easily carried out to abandon the waste fluid of the chromate bath.

Other objects and advantages of the present invention will be apparent from the description with reference to the drawings.

## Brief Description of the Drawings

The drawings show embodiments of a copper foil composite for a printed wiring board and a method of manufacturing same in which:

Fig. 1 is a sectional view of a thin copper foil with a support, and

Fig. 2 is a diagram showing steps of manufacturing a multilayer printed wiring board by utilizing the copper foil with a support.

Detailed Description of the Embodiments

First Embodiment:

As a support 1, an electrolytic copper foil was soaked in sulfuric acid of 5 weight % for 20 seconds and thereafter washed with a city water for 20 seconds. The electrolytic copper foil had a thickness of 70 $\mu$m and a rough surface on a side thereof which surface had a difference of 5 $\mu$m between absolute top and bottom of the rough. The support was soaked in a bath of chromate solution for 60 seconds which solution was prepared by dissolving sodium dichromate in a city water at a concentration of 20g per liter(7.9g per liter as hexavalent chromium ions), so as to form a parting layer (2) thereon. The chromate bath had 4.1 pH and a temperature of 25 ° C. The supporter was washed with a city water for 20 seconds and thereafter immersed in a plating bath of copper and nickel compound metal as identified below, so as to form a copper-nickel layer (3) of 1.0 $\mu$m in thickness on the rough surface thereof by means of cathodic electrolysis.

| | |
|---|---|
| Copper sulfate ($5H_2O$) | : 0.08 mole/$\ell$ |
| Nickel sulfate ($6H_2O$) | : 0.16 mole/$\ell$ |
| Citric acid | : 0.5 mole/$\ell$ |
| pH | : 5.2 |
| Bath temperature | : 40° C |
| Current density of cathode | : 3 A/dm$^2$ |
| Time | : 4 minutes |

Analysis of the compound metal deposited in this plating showed copper of 75 weight % and nickel of 25 weight %.

Then, the support was washed with a city water for 30 seconds and thereafter a thin copper foil layer (4) of 5 $\mu$m was formed on the compund metal layer by utilizing a plating bath of copper-pyrophosphate, which is identified below.

| | |
|---|---|
| Copper pyrophosphate | : 80 g/$\ell$ |
| Potassium pyrophosphate | : 290 g/$\ell$ |
| Ammonia water | : 3 m$\ell$/$\ell$ |

(Specific gravity:0.85)

The copper plating bath had pH of 8.7 and a temperature of 57° C and the plating was carried out with a current density of cathode of 4 A/dm$^2$ for 5 minutes and 38 seconds. Thereafter, the thin copper foil with the support was washed with a city water for 30 seconds and immediately dried by a hot air dryer.

To make a multilayer printed wiring board, a glass-epoxy prepreg (NEMA grade FR-4) was laid on both sides of an inner layer panel or board and further the thin copper foil with the support was laid thereon in such a manner that the thin copper foil layer faced the prepreg, and thereafter laminated under the conditions of high pressure and temperature (at 165 ° C under 50 kg/cm$^2$ for 60 minutes). Next, the laminated board was holed by means of a drill having a diameter of 1 mm and then the copper foil support was peeled off from the laminated board. The peel strength of the support was 60 g/cm and its peeling was easily carried out by hand over the laminated board. Further, no partial separation was found on the compound metal layer around the drilled holes. To form an electric conductor in each of the holes of the laminated board, a tendency of soft-etching was checked by immersing in a aqueous solution in which ammonium persulfate was dissolved at a concentration of 100g/ $\ell$ after degreasing the board and pickling same. As the result, the compound metal layer of a grayish white color on the surface of the board was completely solved and the thin copper foil of pink appeared. Thereafter, predipping, catalyzing and accelerating treatments were given to the board and electroless copper plating was carried out. Next, the portions of the board except the circuit portions to be neccesitated were covered with a photoresist and a thin copper plating was given to the circuit portions and the electric conductor in the holes by utilizing a copper electroplating bath for through-holes and soldering was carried out thereon. Thereafter, the photoresist used was removed. Finally, the laminated board was etched with an etching liquid of alkaline ammonia in a manner of quick etching so as to make a multilayer board.

The appraisal is shown in Table 1, which follows the end of description of the embodiments.

Second Embodiment:

A rolled copper foil having a thickness of 70 $\mu$m was immersed in a aqueous solution dissolving ammonium persulfate at a concentration of 100 g/$\ell$ and gave a rough treatment to both sides thereof.

According to immersing of the copper foil at a temperature of 40 ° C for 60 seconds, the rough surface showed a value of 1.0 μm as a difference between absolute top and bottom thereof.

The rolled copper foil having rough surfaces was washed with a city water for 45 seconds and then immersed in a chromate bath as identified below so as to form a parting layer on the rough surfaces.

Chromium trioxide             : 1 g/ ℓ
Potassium dichromate          : 3g/ ℓ
pH                            : 2.2
Bath temperature              : 25° C
Immersing time                : 60 seconds

Thereafter, the foil was washed with a city water for 10 seconds and only a side thereof was immersed in a plating bath of copper-nickel compound as identified below and a cathodic electrolysis took place so as to carry out a plating of copper-nickel compound with a thickness of 1.0 μm.

Copper sulfate (5H$_2$O)        : 0.04 mole/ℓ
Nickel sulfate (6H$_2$O)        : 0.15 mole/ℓ
Citric acid                   : 0.4 mole/ℓ

A plating bath of the compound metal had a pH of 5.5. The plating was carried out at a bath temperature of 40 ° C and with a current density of 3. 0 A/dm$^2$ for 4 minutes. The compound metal layer contained a copper of 35 weight %. A support with the compound metal plating was washed with water and thereafter a thin copper foil layer was formed on the compound metal layer with a thickness of 5 μm by using a plating bath of copper sulfate as identified below.

Copper sulfate (5H$_2$O)        : 240 g/ ℓ
Sulfuric acid                 : 70 g/ ℓ

The plating bath was set at a temperature of 40° C and the plating was carried out with a cathodic current density of 3 A/dm$^2$ for four and a half minutes. Thereafter, in order to increase bonding strength with respect to a glass-epoxy prepreg, a copper in a form of dendrite was deposited electrically on the surface of the thin copper foil layer by using a rough treatment bath as identified below.

Copper sulfate (5H$_2$O)        : 120 g/ ℓ
Sulfuric acid                 : 60 g/ ℓ
Nitric acid                   : 20 g/ ℓ

The plating bath was set at a temperature of 40° C and the plating was carried out with a cathodic current density of 25 A/dm$^2$ for 2 minutes. Next, the support was laminated with the prepreg under the same conditions as the first embodiment. Then, the laminated board was checked concerning the peel strength of the support, the presence of exfoliation of the copper-nickel compound metal layer around the drilled holes and a tendency of soft etching with respect to the compound metal layer.

The appraisal is shown in Table 1.

Third to Thirteenth Embodiments:

Electrolytic copper foils for a printed wiring board were utilized. The copper foils had a thickness of 18 μm, 35 μm and 70 μm, respectively and provided a rough surface on a side of each thereof. The rough side of each of the foils were immersed in sulfuric acid of 3 weight % for 30 seconds at a room temperature and then washed with a city water for 60 seconds. A parting layer, a copper-nickel compound metal layer and a thin copper foil layer were given to each of the electrolytic copper foils so as to obtain a thin copper layer with a supporter, respectively. Each of the copper layer with the supporter was laminated with a prepreg under the same conditions as the first embodiment and then each of the laminated boards were checked respectively with respect to the peel strength of the support, the presence of exfoliation of the copper-nickel compound metal layer around the drilled holes and a tendency of soft etching with respect to the compound metal layer.

The appraisals are shown in Table 1.

It is clear from the above mentioned results that a suitable and stable peel strength of the support is obtained at all times by utilizing the copper foil support having rough surfaces and interposing the copper-nickel compound metal layer between the parting layer and the thin copper foil layer, thereby a trouble occurred in peeling off the support from the laminated board is solved.

## Table 1

|  |  | Supporter | | Parting layer | | Cu - Ni Compound Metal Layer | | |
|---|---|---|---|---|---|---|---|---|
|  |  | Thick-ness | Roughness of Rough Surface *1 | Concentration of Chromate Bath | Conditions of Treatment *2 | Composition of Com. Metal Plating Liquid | | |
|  |  |  |  |  |  | Copper Sulfate (5 H₂0) | Nickel Sulfate (6 H₂0) | Citric Acid |
|  |  | μm | μm | g / l | pH | mole / l | | |
| Embodiments | 1 | 70 | 5.0 | Na₂Cr₂O₇:20 | 4.1 | 0.08 | 0.16 | 0.5 |
|  | 2 | " | 1.0 | CrO₃ : 1 / K₂Cr₂O₇ : 3 | 2.2 | 0.04 | 0.15 | 0.4 |
|  | 3 | " | 10.0 | K₂Cr₂O₇ : 20 | 4.2 | 0.08 | 0.16 | 0.5 |
|  | 4 | 18 | 2.0 | CrO₃ : 10 | 6.4 *5 | 0.12 | 0.24 | " |
|  | 5 | 35 | 4.0 | Na₂Cr₂O₇:20 | 4.1 | 0.08 | 0.18 | " |
|  | 6 | 70 | 7.0 | " | " | " | " | " |
|  | 7 | 100 | 10.0 | " | " | " | " | " |
|  | 8 | 70 | 5.0 | " | " | 0.04 | 0.24 | 0.4 |
|  | 9 | " | " | " | " | 0.12 | 0.07 | 0.3 |
|  | 10 | " | " | " | " | 0.08 | 0.16 | 0.5 |
|  | 11 | " | " | " | " | " | " | " |
|  | 12 | " | " | " | " | " | " | " |
|  | 13 | " | " | " | " | " | " | " |
| Comparative Exam. | 1 | 70 | Luster Surface (0.2μm) | Cr Plating Layer (0.06 μm) | | | | |
|  | 2 | 70 | Rough Surface (0.5μm) | " (1.0 μm ) | | | | |

Cont./-

*1..Value showing a difference between the absolute top and bottom.
*2..Bath temperature constant at 25 °C. Immersing time constant for 60 seconds.

Table 1

| Cu – Ni Compound Metal Layer (Conditions of Plating) | | | | Cu Foil Layer | | Appraisal | | |
|---|---|---|---|---|---|---|---|---|
| Time of Plating pH*5 | Minutes | Thickness μm | Composition of Com.Metal wt%Cu | Plating Bath | Thickness μm | Peel Strength g/cm | Damage of Copper Foil Around Drilled Holes | Capability of Soft Etching of Com.Metal Layer *4 |
| 5.2 | 4.0 | 1.0 | 75 | Copper Pyrophosphate 3 | 5.0 | 60 | None | Good |
| 5.5 | ″ | ″ | 35 | Copper Sulfate | ″ | 35 | None | Good |
| 5.2 | ″ | ″ | 75 | Above | ″ | 100 | None | Good |
| ″ | 0.4 | 0.1 | ″ | ″ | ″ | 40 | None | Good |
| ″ | 4.0 | 1.0 | ″ | ″ | ″ | 55 | None | Good |
| ″ | ″ | ″ | ″ | ″ | ″ | 80 | None | Good |
| ″ | ″ | ″ | ″ | ″ | ″ | 115 | None | Good |
| ″ | ″ | ″ | 13 | ″ | ″ | 65 | None | Good |
| ″ | ″ | ″ | 86 | ″ | ″ | 63 | None | Good |
| 5.4 | 24.0 | 6.0 | 75 | ″ | ″ | 68 | None | Good |
| 5.2 | 4.0 | 1.0 | ″ | ″ | ″ | 65 | None | Good |
| ″ | ″ | ″ | ″ | ″ | 1.0 | 61 | None | Good |
| ″ | ″ | ″ | ″ | ″ | 1.9 | 64 | None | Good |
| | | | | ″ | 5.0 | 150~500 | Damage found | — |
| | | | | ″ | ″ | 2 | — | — |

*3.. Bath temperature constant at 40°C. Current density constant at 3 A/dm². 
*4.. Checking if the compound metal layer is solved completely by immersing same in an aqueous solution including an ammonium persulfate of 100 g/ℓ. When solved, its appraisal is good. 
*5.. The pH is controlled with a caustic soda.

Comparative Example - 1

As a support, a rolled luster copper foil, which had a rough surface having a difference of 0.2μ m between the absolute top and bottom of the rough, was immersed in a sulfuric acid of 5 weight % at a temperature of 25° C for 60 seconds and washed with a city water for 30 seconds. Then, a side of the copper foil was immersed in a plating bath as identified below and a cathodic electrolysis was carried out so as to make a chrome plating

7

of 0.06 μm in thickness on the side thereof.

| Chromium trioxide | : 350 g/ ℓ |
| Sulfuric acid | : 3.5 g/ ℓ |
| Bath temperature | : 27° C |
| Cathodic current density | : 11.0 A/dm$^2$ |
| Immersing time | : 30 seconds |
| Anode | : Lead |

After the chrome deposited support was washed with a city water for 60 seconds, a thin copper foil layer of 5.0 μm in thickness was formed thereon by using a plating bath of copper pyrophosphate and the same plating conditions as the first embodiment. Thereafter, the thin copper foil layer with the supporter was washed immediately with a city water for 30 seconds and dried by a hot air dryer. The thin copper foil with the support was laminated with a prepreg under high pressure and high temperature (at 165° C under 50 kg/cm$^2$ for 60 seconds) and then holed by a drill having a diameter of 1 mm and the support was peeled off. The peel strength of the support was dispersed widely from 150 to 500 g/cm. A part of the thin copper foil layer around the drilled holes was injured by the support which was peeled off and such an injured portion was found around a number of the drilled holes.

Comparative Example - 2

As a supporter, a copper foil was utilized which had a thickness of 70 μm and rough surfaces having a difference of 5 μm between the absolute top and bottom of the rough. The rough surface of the copper foil was pickled, washed with water and deposited with chrome in the same manner as the comparative example - 1. The immersing time was regulated so that the thickness of chrome plating became 1 μm. The chrome deposited support was washed with a city water for 45 seconds and a thin copper foil layer having a thickness of 5 μm was formed by using a plating bath of copper pyrophosphate which was the same as the first embodiment. Thereafter, it was washed with a city water for 30 seconds and dried by a dryer. Then, the thin copper foil layer with the supporter was laminated with a prepreg (NEMA grade FR-4) under high pressure and temperature (at 165° C under 50 kg/cm$^2$ for 60 seconds) in such a manner that the thin copper foil layer faced the prepreg. While the laminated board was taken out from a press machine, a number of swelling of the copper foil support which had a diameter of 1 to 2 cm, were found on the surface of the laminated board. When the laminated board was cut to have a size required, the copper foil support was peeled off from the board and it became difficult to be drilled in the next step. When the peel strength of the support was measured, it was 2g/cm.

Through the first and second embodiments as well as the comparative examples 1 to 13, the following facts should be noted.

As the thin copper foil for the printed wiring board:

Through the test and checking of the peel strength of the support, it is found that there is not a particular problem in the course of processes necessary for a printed wiring board in the event that the peel strength belongs to a range of 20~200g/cm with a test of peeling at 90 degrees.

Where the peel strength is less than 20g/cm, it will be dangerous that the copper foil support is peeled off while laminating the prepreg and the thin copper foil with the support under high pressure and temperature or while drilling the thin copper foil. Further, it is found that it is not preferable to exceed the peel strength more than 200g/cm, since a remarkable force is necessary to peel off the copper foil supporter particularly in a case that the laminated board is prepared in large scale and it becomes sometimes dangerous that the thin copper foil layer is injured or broken around the drilled holes.

On the basis of the facts, the inventors have checked the influence of a shape of the rough surface of the copper foil support on the peel strength of the supporter. As the results, it has been found that as a degree of rough of the rough surface it is preferable to have a difference of 1~10 μm between the absolute top and bottom of the rough surface. However, it is not perferable in such cases that where the difference of the absolute top and bottom is less than 1 μm, the peel strength between the parting layer and the copper-nickel compound metal layer sometimes becomes less than 20g/cm, and that where the difference between the absolute top and bottom exceeds 10 μm, it sometimes occurrs that the peel strength exceeds 200g/cm.

The thickness of the copper foil support is normally set at 70 μm, but it may be more than 18 μm or less than 100 μm. It is not preferable in such a case that the thickness of the copper foil support is less than 18 μm, since creases occur with the copper foil support while handling same even if the copper-nickel compound metal layer having a thickness of 6.0 μm and the thin copper foil layer having a thickness of 9.0 μm are laminated together via a parting layer by means of a plating process.

Contrary to this, it is not preferable in such a case that the thickness of the copper foil support exceeds

100 μm, since the peel strength of the supporter sometimes exceeds 200g/cm due to rigidity of the copper foil per se.

It is perferable that the parting layer formed on the rough surface of the copper foil support is a chrome compound obtained by means of a chromate treatment. As the parting layer, it may be possible to form another parting layer in such a manner that copper oxides, copper sulfide, silver iodide or the like is formed on the copper foil support and then a thin copper foil layer is deposited on the parting layer by means of an electric plating process. However, such a manner has to be carried out very carefully in forming the parting layer in order to stabilize the peel strength of the support. The parting layer according to the present invention has a characteristic in stabilizing the peel strength of the support in such a manner that the copper-nickel compound metal layer is interposed between the thin copper foil layer and the chromate compounds which are obtained by means of a chromate streatment.

Further, it is preferable that the thickness of the compound metal layer is between 0.01 μm and 6.0 μ m. It is not preferable that the thickness is less than 0.01 μm, since it causes occurrence of pinholes as the compound metal layer cannot cover the parting layer completely.

The maximum thickness of the compound metal layer is determined according to a solving speed in a soft etching process. Normally, according to the conditions used by the manufacturers in the field of printed wiring boards, the solving amount is 6.0 μm per 3 minutes of tretment at maximum. Therefore, it is preferable to control the maximum thickness of the compound metal layer less than 6.0 μm.

The compound metal layer has to be solved and removed in a soft etching process for the printed wiring board. A soft etching liquid normally used is an etching liquid which includes at least one of those, i.e. sulfuric acid - hydrogen peroxide, persulfates, ferric chloride, cupric chloride or ammonia double salts.

The copper-nickel compound metal layer may be solved in general soft etching liquids. It is more preferable that the composition of the copper-nickel compound metal layer includes a copper in a range of 10 to 90 weight %, but it is not preferable that the copper is less than 10 weight % since it takes much time to carry out soft etching. Further, it is not preferable to use the copper-nickel compound metal layer in which a copper exceeds 90 weight % since the peel strength of the support sometimes becomes less than 20g/cm.

The thickness of the thin copper foil layer, which is formed on the copper-nickel compound layer, is 1 ~ 9 μm. In a soft etching process, it aims at completely removing the copper-nickel compound layer which is located at the extreme top surface, and exposing the thin copper foil layer which is an underlayer. It is not preferable that the thickness of the thin copper foil layer is less than 1 μm, since there is a danger to solve and remove even the thin copper foil layer with an excessive etching. The thickness of the thin copper foil layer as mentioned before includes the rough surface though there is a case that the rough surface is formed with the thin copper foil layer in order to improve a bonding strength to the prepreg.

As the method of manufacturing the microscopic thin copper foil for a printed wiring board:

As a method of roughening the copper foil supporter, there may be itemized below.

① A chemical etching process in which a copper foil is immersed in an aqueous solution including ammonium persulfate of 20 ~100 g/ℓ for 20 ~100 seconds by keeping a temperature of its bath at 30~50° C.

② A mechanical griding in which a copper foil is ground by a file.

③ A plating process in which a copper foil is plated in a copper plating bath including copper sulfate ($5H_2O$) of 100 ~ 50 g/ℓ, sulfuric acid of 50 ~ 80 g/ℓ, nitric acid of 10 ~ 50 g/ℓ, with cathodic current density of 18 ~ 32 A/dm², at a bath temperature of 35~50° C for an electrolytic time of 60~180 seconds.

④ A manner of utilizing a copper foil for electrolysis having a rough surface on a side thereof, which copper foil is well known in the art of this field as a copper foil for a printed wiring board.

It is preferable to form the parting layer by immersing the rough surface of the copper foil support in a chromate bath which includes hexavalent chromium ions and keeps its pH at 2.0 ~ 6.5.

The pH of the chromate bath influences the peel strength of the support. When the pH is less than 2.0 or exceeds 6.5, it is difficult to form the parting layer and therefore it is difficult to peel off the copper foil support from the board. When the pH is within a range of 2.0~6.5, the peel strength becomes extremely stable. Sulfuric acid or caustic soda may be used for controlling the pH.

As hexavalent chromium ions, it may use at least one selected from a chromium oxide, potassium dichromate or sodium dichromate. It is preferable to use a chromate bath including 0.1g/ℓ of hexavalent chromium ions. There is a disavantage in such a case that a concentration of the hexavalent chromium ions is less than 0.1g/ ℓ, since the peel strength of the supporter becomes high. There is no influence on the peel strength of the support even if the concentration of the hexavalent chromium ions becomes too high, but it costs a great deal in dealing with the waste fluid of the chromate bath. Preferably, the concentration of the hexavalent chromium ions is within a range of 5~ 20/ℓ.

As the compound metal layer, it is preferable to use a copper-nickel compound metal layer which may be obtained by immersing the parting layer in a plating bath of compound metal which includes cupric ions and

EP 0 398 721 B1

nickel ions and keeps its pH more than 5.0, and by giving thereto a cathodic electrolysis.

As the plating bath of compound metal, it is preferable to use such a bath which includes copper sulfate ($5H_2O$) of 0.04~0.12 mole/$\ell$ as cupric ions, nickel sulfate ($6H_2O$) of 0.07 ~0.12 mole/$\ell$ as nickel ions, and citric acid of 0.3 ~ 0.5 mole/$\ell$.

When the pH of the plating bath of compound metal is less than 5.0, the parting layer given onto the rough surface of the copper foil supporter is broken and a peeling effect may be reduced and as the result it becomes hard to peel off the copper foil supporter. When the pH is more than 5.0, the peel strength of the support always indicates a stable value.

To add a citric acid to the plating bath of the compound metal is to prepare a chelate compound combining a cupric ion and a nickel ion. However, there are chemicals to prepare a chelate, but it is found that when the citric acid is used, it may deposit a compound metal coat like a plating which coat has little pinholes. Where a chelate such as a citric acid is not added, only a copper is deposited with priority and it does not form a copper-nickel compound coat or deposit a porous compound metal layer in the state of powders.

Next, the copper-nickel compound metal layer is immersed in a copper electric plating bath and a thin copper foil layer having a thickness of 1 ~ 9 μm is deposited by means of cathodic electrolysis.

The electric copper plating bath referred to herein indicates a plating bath of cupric pyrophosphate, a plating bath of copper sulfate, a plating bath of copper cyanide, copper fluoride and any one of those baths may be used.

Further, it is preferable to deposit copper in the state of dendrite on the surface of the thin copper foil layer in order to improve the bonding strength of the thin copper foil layer to the prepreg.


## Claims

1. A copper foil composite for a printed circuit board comprising:
   a peelable support of copper foil (1), having a surface on one side whose roughness is such that the distance between the upper and lower extremeties thereof is in the range 1μm to 10μm,
   a separating layer (2) formed on said surface,
   a copper-nickel alloy layer (3) formed on said separating layer, and a copper foil layer (4) of thickness 1 to 9μm formed on said separating layer.

2. A copper foil composite according to claim 1 wherein said separating layer (2) is composed of copper oxides, copper sulphide, silver iodide or chrome compounds obtainable by chromate treatment.

3. A copper foil composite according to claim 1 or claim 2 wherein said copper-nickel alloy layer (3) comprises 10-90 weight % copper, the balance consisting of nickel and the thickness of said alloy layer is in the range 0.01 μm to 6μm.

4. A copper foil composite according to any preceding claim wherein said peelable support has a thickness in the range 18 μm to 100 μm.

5. Use of a copper foil composite as claimed in any preceding claim for making a printed circuit board.

6. A method of making a copper foil composite for a printed circuit board, the method comprising:
   a) roughening the surface of a peelable support of copper foil (1)
   b) forming a separating layer (2) on said roughened surface.
   c) depositing a copper-nickel alloy layer (3) on said separating layer from a plating bath, and
   d) depositing a copper foil layer (4) of thickness 1 to 9 μm on said alloy layer from a plating bath.

7. A method according to claim 6 wherein the surface roughness of said roughened surface is such that the distance between the upper and lower extremeties thereof is in the range 1 μm to 10 μm.

8. A method according to claim 6 or claim 7 wherein said separating layer (2) is formed by immersing said roughened surface in a chromate bath comprising hexavelant chromium ions and maintain the pH in the range 2.0 to 6.5.

9. A method according to claim 8 wherein said copper-nickel alloy layer (3) is formed by electro-deposition from a plating bath including cupric ions, nickel ions and citric acid whilst maintaining the pH above pH 5.0.

10. A method according to claim 8 or claim 9 wherein said chromate bath comprises at least one of: chromium trioxide, potassium dichromate and sodium dichromate and the plating bath used to deposit the copper-nickel alloy layer (3) contains:
0.04 to 0.12 mole/litre $CuSo_4.5H_2O$
0.07 to 0.24 mole/litre $NiSO_4.6H_20$
0.3 to 0.5 mole/litre citric acid

## Patentansprüche

1. Verbundkupferfolie für eine gedruckte Schaltungsplatte, bestehend aus:
einem ablösbaren Kupferfolienträger (1), der auf einer Seite eine Oberfläche aufweist, deren Rauhigkeit derart ist, daß der Abstand zwischen dem oberen und dem unteren Extremum derselben im Bereich von 1 μm bis 10 μm liegt, eine Trennungsschicht (2), die auf der genannten Oberfläche gebildet ist, eine Schicht (3) einer Kupfer-Nickel-Legierung, die auf der Trennungsschicht gebildet ist und eine Kupferfolienschicht (4) mit einer Dicke von 1 bis 9 μm, die auf der Trennungsschicht gebildet ist.

2. Verbundkupferfolie nach Anspruch 1, **dadurch gekennzeichnet**, daß die Trennungsschicht (2) aus Kupferoxiden, Kupfersulfid, Silberiodid oder mittels Chromatbehandlung erhältlicher Chromverbindungen besteht.

3. Verbundkupferfolie nach Anspruch 1 oder 2, **dadurch gekennzeichnet**, daß die Schicht (3) der Kupfer-Nickel-Legierung 10 bis 90 Gewichts % Kupfer enthält, wobei der Rest Nickel ist und die Dicke der Legierungsschicht im Bereich von 0,01 μm bis 6 μm liegt.

4. Verbundkupferfolie nach einem der vorhergehenden Ansprüche, **dadurch gekennzeichnet**, daß der ablösbare Träger eine Dicke im Bereich von 18 bis 100 μm aufweist.

5. Verwendung einer Verbundkupferfolie wie in einem der vorhergenden Ansprüche beansprucht, zur Herstellung von gedruckten Schaltungsplatten.

6. Verfahren zur Herstellung einer Verbundkupferfolie für gedruckte Schaltungsplatten, wobei das Verfahren beinhaltet:
a) Aufrauhung der Oberfläche eines ablösbaren Kupferfolienträgers (1),
b) Bildung einer Trennungsschicht (2) auf der aufgerauhten Oberfläche.
c) Abscheidung einer Schicht (3) einer Kupfer-Nickel-Legierung auf der Trennungsschicht aus einem Abscheidungsbad und
d) Abscheidung einer Kupferfolienschicht (4) mit einer Dicke von 1 bis 9 μm auf der Legierungsschicht aus einem Abscheidungsbad.

7. Verfahren nach Anspruch 6, **dadurch gekennzeichnet**, daß die Oberflächenrauhigkeit der aufgerauhten Oberfläche derart ist, daß der Abstand zwischen dem obersten und niedrigstem Extremum derselben im Bereich von 1 μm bis 10 μm liegt.

8. Verfahren nach Anspruch 6 oder 7, **dadurch gekennzeichnet**, daß die Trennungsschicht (2) durch Eintauchen der aufgerauhten Oberfläche in ein Chromatbad gebildet wird, welches sechswertige Chromionen enthält und dessen pH-Wert im Bereich von 2,0 bis 6,5 gehalten wird.

9. Verfahren nach Anspruch 8, **dadurch gekennzeichnet**, daß die Schicht (3) der Kupfer-Nickel-Legierung durch Elektro-Abscheidung aus einem Abscheidungsbad gebildet wird, welches Kupferionen, Nickelionen und Zitronensäure enthält, während der pH-Wert oberhalb des pH-Wertes 5,0 gehalten wird.

10. Verfahren nach Anspruch 8 oder 9, **dadurch gekennzeichnet**, daß das Chromatbad zumindest einen der folgenden Stoffe enthält: Chromtrioxid, Kaliumdichromat und Natriumdichromat und daß das zur Abscheidung der Schicht der Kupfer-Nickel-Legierung (3) verwendete Abscheidungsbad enthält:
0,04 bis 0,12 mol/l $CuS0_4.5H_20$

0,07 bis 0,24 mol/l NiSO$_4$.6H$_2$0

0,3 bis 0,5 mol/l Zitronensäure

## Revendications

1. Composite en feuille de cuivre pour carte de circuit imprimé comprenant:
   un support pelable en feuille de cuivre (1), ayant une surface sur l'un des côtés dont la rugosité est telle que la distance entre les extrémités supérieures et inférieures de celle-ci est comprise dans l'intervalle allant de 1 μm à 10 μm,
   une couche intercalaire (2) formée sur ladite surface,
   une couche en alliage cuivre-nickel (3) formée sur ladite couche intercalaire, et une couche en feuille de cuivre (4) d'épaisseur comprise entre 1 et 9 μm formée sur ladite couche intercalaire.

2. Composite en feuille de cuivre selon la revendication 1 dans lequel ladite couche intercalaire (2) est composée d'oxydes de cuivre, de sulfure de cuivre, d'iodure d'argent ou de dérivés de chrome obtenus par traitement au chromate.

3. Composite en feuille de cuivre selon la revendication 1 ou la revendication 2 dans lequel ladite couche en alliage cuivre-nickel (3) comprend 10 à 90 % en poids de cuivre, le reste étant constitué de nickel et l'épaisseur de ladite couche en alliage étant comprise dans l'intervalle allant de 0,01 μm à 6 μm.

4. Composite en feuille de cuivre selon l'une quelconque des revendications précédentes dans lequel ledit support pelable présente une épaisseur comprise dans l'intervalle allant de 18 μm à 100 μm.

5. Utilisation de composite en feuille de cuivre tel que revendiqué dans l'une quelconque des revendications précédentes pour fabriquer une carte de circuit imprimé.

6. Procédé de fabrication d'un composite en feuille de cuivre pour carte de circuit imprimé, procédé comprenant:
   a) le décapage de la surface d'un support pelable en feuille de cuivre (1)
   b) la formation d'une couche intercalaire (2) sur ladite surface décapée,
   c) le dépôt d'une couche en alliage cuivre-nickel (3) sur ladite couche intercalaire à l'aide d'un bain de placage, et
   d) le dépôt d'une couche en feuille de cuivre (4) d'épaisseur comprise entre 1 et 9 μm sur ladite couche en alliage à l'aide d'un bain de placage.

7. Procédé selon la revendication 6 dans lequel la rugosité de surface de ladite surface décapée est telle que la distance entre les extrémités supérieures et inférieures de celle-ci est comprise dans l'intervalle allant de 1 μm à 10 μm.

8. Procédé selon la revendication 6 ou la revendication 7 dans lequel ladite couche intercalaire (2) est formée par immersion de ladite surface décapée dans un bain de chromate comprenant des ions hexavalents de chrome et en veillant à ce que la valeur du pH demeure comprise dans l'intervalle allant de 2,0 à 6,5.

9. Procédé selon la revendication 8 dans lequel la couche en alliage cuivre-nickel (3) est formée par dépôt électrolytique à l'aide d'un bain de placage comprenant des ions cuivriques, des ions nickel et de l'acide citrique en maintenant la valeur du pH au-dessus de 5,0.

10. Procédé selon la revendication 8 ou la revendication 9 dans lequel ledit bain de chromate comprend au moins l'un des produits suivants: trioxyde de chrome, dichromate de potassium et dichromate de sodium et le bain de placage utilisé pour déposer la couche en alliage cuivre-nickel (3) contient:
    0,04 à 0,12 mole/litre de CuSO$_4$.5H$_2$O
    0,07 à 0,24 mole/litre de NiSO$_4$.6H$_2$O
    0,3 à 0,5 mole/litre d'acide citrique.

# Fig. 1

# Fig. 2